(19) Europäisches Patentamt / European Patent Office / Office européen des brevets

(11) **EP 3 379 707 B1**

## (12) FASCICULE DE BREVET EUROPEEN

(45) Date de publication et mention de la délivrance du brevet:
**02.10.2019 Bulletin 2019/40**

(21) Numéro de dépôt: **18162602.9**

(22) Date de dépôt: **19.03.2018**

(51) Int Cl.:
*H02M 1/12* (2006.01)     *H02M 1/14* (2006.01)
*H02J 3/01* (2006.01)     *B60L 9/00* (2019.01)

(54) **CIRCUIT ÉLECTRIQUE DE FILTRAGE, SYSTÈME D'ALIMENTATION COMPRENANT UN TEL CIRCUIT ET VÉHICULE FERROVIAIRE ASSOCIÉ**

ELEKTRISCHER FILTERSCHALTKREIS, STROMVERSORGUNGSSYSTEM, DAS EINEN SOLCHEN SCHALTKREIS UMFASST, UND ENTSPRECHENDES SCHIENENFAHRZEUG

ELECTRICAL FILTER CIRCUIT, POWER SUPPLY SYSTEM COMPRISING SUCH A CIRCUIT AND ASSOCIATED RAILWAY VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.03.2017 FR 1752400**

(43) Date de publication de la demande:
**26.09.2018 Bulletin 2018/39**

(73) Titulaire: **ALSTOM Transport Technologies**
**93400 Saint-Ouen (FR)**

(72) Inventeurs:
• **DUBREUIL, Fabien**
**65000 Tarbes (FR)**
• **MAUMY, François**
**64460 Monségur (FR)**
• **BOYER, Michel**
**65000 Tarbes (FR)**

(74) Mandataire: **Lavoix**
**2, place d'Estienne d'Orves**
**75441 Paris Cedex 09 (FR)**

(56) Documents cités:
**EP-A2- 1 610 450     DE-A1- 2 636 668**
**FR-A1- 2 418 570     FR-A1- 3 024 613**

**Description**

La présente invention concerne un circuit électrique de filtrage d'une alimentation électrique d'un véhicule ferroviaire via un pantographe propre à être en contact électrique avec une caténaire, le circuit électrique comprenant un filtre comportant une bobine électromagnétique et un condensateur connecté en parallèle de la bobine électromagnétique, le filtre ayant une fréquence propre.

L'invention concerne également un système d'alimentation d'un véhicule ferroviaire, comprenant un tel circuit du filtrage.

L'invention concerne également un véhicule ferroviaire.

L'invention concerne le domaine du filtrage d'un courant d'alimentation d'un véhicule ferroviaire, en particulier une motrice ferroviaire comportant un moteur et un système d'alimentation du moteur notamment par courant alternatif. Le filtrage est effectué avec des éléments passifs, tels que des bobines électromagnétiques et des condensateurs.

On connaît du document FR 2 418 570 A1 un circuit électrique de filtrage de type précité. Le circuit électrique comporte une bobine électromagnétique et un condensateur connectés en parallèle, formant ainsi un circuit LC, aussi appelé « circuit bouchon ».

Dans un tel circuit électrique de filtrage, l'énergie entre un champ magnétique de la bobine électromagnétique et un champ électrique du condensateur est échangée de manière périodique. En conséquence, un courant fort alterne avec une tension forte dans le circuit électrique de filtrage. La fréquence à laquelle cet échange d'énergie est répété de manière périodique est la fréquence propre du circuit électrique de filtrage. La valeur de la fréquence propre dépend de la valeur de l'impédance de la bobine électromagnétique et de la valeur de la capacité du condensateur.

Toutefois, le filtrage opéré par un tel circuit électrique de filtrage n'est pas optimal.

Le but de l'invention est donc de proposer un circuit électrique de filtrage offrant un meilleur filtrage, et permettant notamment de filtrer une bande de fréquences du courant d'alimentation du véhicule ferroviaire, afin d'avoir une réception de signaux avec une moindre perturbation pour une ou plusieurs antennes de réception embarquées à bord du véhicule ferroviaire.

À cet effet, l'invention a pour objet un circuit électrique de filtrage d'une alimentation électrique d'un véhicule ferroviaire, le véhicule étant alimenté via un pantographe propre à être en contact électrique avec une caténaire, le circuit électrique comprenant un premier filtre, le premier filtre comportant une première bobine électromagnétique et un premier condensateur connecté en parallèle de la première bobine électromagnétique, le premier filtre ayant une première fréquence propre, le circuit électrique de filtrage comprenant en outre un deuxième filtre, le deuxième filtre comportant une deuxième bobine électromagnétique et un deuxième condensateur connecté en parallèle de la deuxième bobine électromagnétique, le deuxième filtre ayant une deuxième fréquence propre distincte de la première fréquence propre, le premier filtre et le deuxième filtre étant connectés en série et étant configurés pour être disposés entre le pantographe et un transformateur relié électriquement à une roue du véhicule ferroviaire, l'un des premier et deuxième filtres étant configuré pour être connecté directement au transformateur.

Le circuit électrique selon l'invention comporte alors deux fréquences propres, distinctes l'une de l'autre, et permet d'atténuer des perturbations dans une bande de fréquences autour de ces deux fréquences propres. Ces perturbations proviennent, par exemple, d'un saut du pantographe sur la caténaire ou d'un arc électrique lors de l'actionnement d'un disjoncteur connecté au pantographe.

Avec le circuit électrique de l'état de la technique, ayant une unique fréquence propre, la bande de fréquence filtrée est plus étroite, et offre une protection moins efficace de la réception de signaux à l'aide d'antenne(s) radioélectrique(s) contre ces perturbations.

Suivant d'autres aspects avantageux de l'invention, le circuit électrique comprend une ou plusieurs des caractéristiques suivantes, prises isolément ou suivant toute combinaison techniquement possible :

- le premier filtre et le deuxième filtre sont connectés entre eux par un point intermédiaire et seule une extrémité de l'un des premier et deuxième filtres est configurée pour être connectée au transformateur ;
- le point intermédiaire est configuré pour ne pas être directement connecté au transformateur ;
- le circuit électrique de filtrage est configuré pour filtrer des fréquences autour d'une fréquence de filtrage, la fréquence de filtrage étant comprise entre les première et deuxième fréquences propres ;
- la valeur de la fréquence de filtrage est comprise entre 1 MHz et 10 MHz.

L'invention a également pour objet un système d'alimentation d'un véhicule ferroviaire, le système comprenant un pantographe, un disjoncteur, un circuit électrique de filtrage, et un transformateur, le pantographe, le disjoncteur, le circuit électrique de filtrage et le transformateur étant connectés en série et étant configurés pour être connectés électriquement entre une caténaire et une roue du véhicule ferroviaire, le circuit électrique de filtrage étant selon l'une quelconque des revendications précédentes.

Suivant d'autres aspects avantageux de l'invention, le système d'alimentation électrique comprend une ou plusieurs des caractéristiques suivantes, prises isolément ou suivant toute combinaison techniquement possible :

- le système d'alimentation comprend en outre un convertisseur d'énergie électrique configuré pour alimenter électriquement un moteur électrique, le convertisseur d'énergie électrique étant connecté au transformateur ;

- le transformateur comporte un enroulement primaire et un enroulement secondaire, et le circuit électrique de filtrage est connecté à l'enroulement primaire ;
- le transformateur comporte un enroulement primaire et un enroulement secondaire, et le convertisseur d'énergie électrique est connecté à l'enroulement secondaire.

L'invention a également pour objet un véhicule ferroviaire comprenant un moteur électrique, un système d'alimentation du moteur électrique, le système d'alimentation étant tel que précédemment décrit.

Ces caractéristiques et avantages de l'invention apparaitront à la lecture de la description qui va suivre, donnée uniquement à titre d'exemple non limitatif, et faite en référence aux dessins annexés, sur lesquels :

- la figure 1 est une représentation schématique d'un véhicule ferroviaire comprenant un moteur électrique et un système d'alimentation du moteur électrique, le système d'alimentation étant relié à une caténaire ;
- la figure 2 est une courbe de réponse en fréquence d'un circuit de filtrage inclus dans le système d'alimentation de la figure 1.

Dans la suite de la description, l'expression « sensiblement égal à » s'entend par une relation d'égalité à plus ou moins 10%, de préférence à plus ou moins 5%.

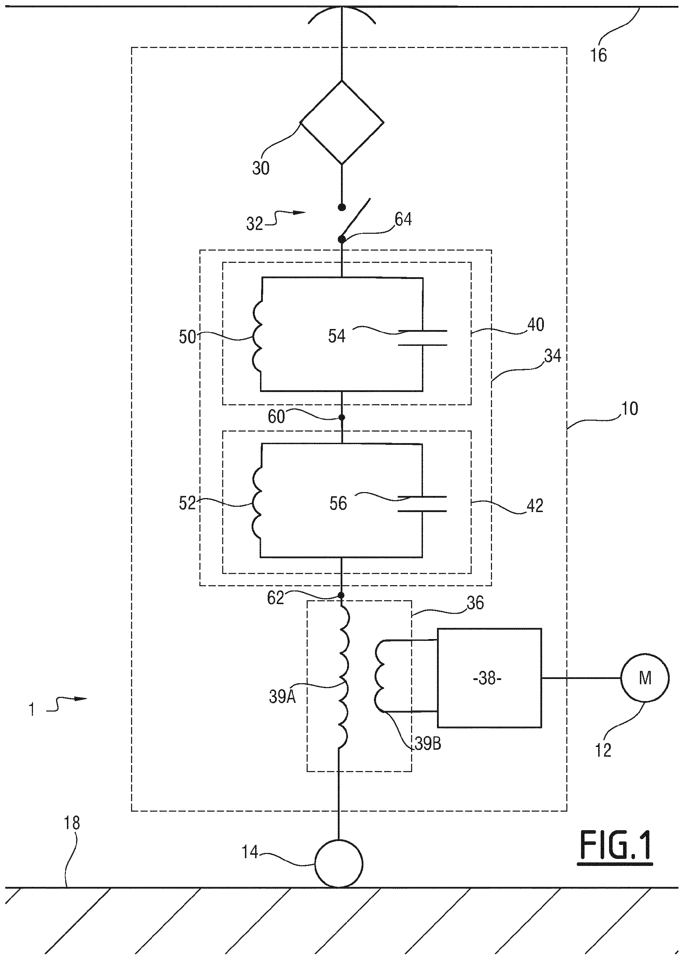

Sur la figure 1, un véhicule ferroviaire 1 comporte un système d'alimentation électrique 10, un moteur électrique 12 alimenté par le système d'alimentation 10 et plusieurs roues 14, seule une roue 14 étant représentée par souci de simplification du dessin. Le système d'alimentation électrique 10 est configuré pour être connecté électriquement à une caténaire 16 d'une part, et à au moins la roue 14 du véhicule ferroviaire 1 d'autre part. Le système d'alimentation électrique 10 est configuré pour alimenter le moteur électrique 12 du véhicule ferroviaire 1.

Le système d'alimentation électrique 10 comporte, connectés en série, un pantographe 30, un disjoncteur 32, un circuit électrique de filtrage 34 et un transformateur électrique 36. Le système d'alimentation électrique 10 comporte en outre un convertisseur d'énergie électrique 38 connecté au transformateur 36.

Le moteur électrique 12 du véhicule ferroviaire est par exemple un moteur à courant alternatif. En variante, le moteur électrique 12 est un moteur à courant continu. Il est configuré pour tracter le véhicule ferroviaire 1.

Chaque roue 14 du véhicule ferroviaire est disposée sur un rail 18. Chaque roue 14 et les rails 18 sont au potentiel électrique de la terre. En conséquence, la connexion du système d'alimentation 10 à au moins une roue 14 forme une mise à la terre du système d'alimentation électrique 10, c'est-à-dire une connexion à une masse électrique.

Le pantographe 30 est connecté au disjoncteur 32, et est configuré pour être relié électriquement à la caténaire 16, par contact avec celle-ci. Le pantographe 30 est configuré pour recevoir une tension de la part de la caténaire 16. La tension d'alimentation fournie par la caténaire 16 est une tension alternative, telle par exemple qu'une tension monophasée d'environ 25 kV à 50 Hz.

Le disjoncteur 32 est configuré pour protéger la liaison électrique entre le pantographe 30 et le circuit électrique 34 contre les surintensités.

Le circuit électrique de filtrage 34 est de préférence connecté directement au transformateur électrique 36. Le circuit électrique de filtrage 34 comporte un premier filtre 40 et un deuxième filtre 42 connectés en série. Il est configuré pour filtrer une bande de fréquences du courant d'alimentation du véhicule ferroviaire 1 autour d'une fréquence de filtrage F0.

Le transformateur 36 est connu en soi et configuré pour modifier la valeur de tension en entrée du convertisseur d'énergie électrique 38, à partir de la tension fournie par la caténaire 16. Par exemple, la tension de la caténaire 16 est sensiblement égale à 25 kV, et le moteur 12 fonctionne à une tension plus basse. Le transformateur électrique 36 est alors configuré pour abaisser la tension d'alimentation fournie par la caténaire 16 à une tension plus basse, en entrée du convertisseur d'énergie électrique 38.

Le transformateur 36 comporte un enroulement primaire 39A connecté au circuit électrique de filtrage 34. L'enroulement primaire 39A est en outre relié électriquement à la roue 14 du véhicule ferroviaire 1. Le transformateur 36 comporte en outre un enroulement secondaire 39B connecté au convertisseur d'énergie électrique 38.

Le convertisseur d'énergie électrique 38 est connecté entre le transformateur électrique 36 et le moteur électrique 12. Il est configuré pour convertir une fréquence de tension d'alimentation en entrée en une autre fréquence de tension en sortie, afin d'alimenter électriquement le moteur 12 à la fréquence désirée. Le convertisseur d'énergie électrique 38 comporte un redresseur, non représenté, configuré pour convertir un courant alternatif issu du transformateur 36 en un courant continu, suivi d'un onduleur, non représenté, configuré pour convertir le courant continu issu du redresseur en un courant alternatif fourni en entrée du moteur. Au sein du convertisseur d'énergie électrique 38, le redresseur et l'onduleur sont reliés entre eux par un bus continu, non représenté.

Les premier et deuxième filtres 40, 42 sont configurés pour être disposés entre le pantographe 30 et le transformateur 36 et forment le circuit électrique de filtrage 34. Par exemple, le deuxième filtre 42 est connecté directement au transformateur 36.

Chaque filtre 40, 42 comprend respectivement une bobine électromagnétique 50, 52 et un condensateur 54, 56. Dans l'exemple de la figure 1, le premier filtre 40 comprend une première bobine électromagnétique 50 et un premier condensateur 54 connecté en parallèle de la première bobine électromagnétique 50. En outre, le premier filtre 40 a une première fréquence propre F1.

Le deuxième filtre 42 comprend une deuxième bobine électromagnétique 52 et un deuxième condensateur 56 connecté en parallèle de la deuxième bobine électromagnétique 52. Le deuxième filtre 42 a une deuxième fréquence propre F2.

Les premier et deuxième filtres 40, 42 sont connectés entre eux en série. Les premier et deuxième filtres 40, 42 sont connectés entre eux en un point intermédiaire 60. De préférence, le point intermédiaire 60 n'est pas directement connecté au transformateur 36. De préférence, seule une extrémité 62 du deuxième filtre 42 est connectée directement au transformateur électrique 36. Une extrémité 64 du premier filtre 40 est connectée au disjoncteur 32.

En variante, non représentée, les premier et deuxième filtres 40, 42 sont configurés pour être disposés entre le pantographe 30 et le disjoncteur 32. Par exemple, l'extrémité 64 du premier filtre 40 est configurée pour être connectée au pantographe 30 et l'extrémité 62 du deuxième filtre 42 est connectée au disjoncteur 32.

La valeur de la première fréquence propre F1 du premier filtre 40 dépend des valeurs de l'inductance de la première bobine électromagnétique 50 et de la capacité du premier condensateur 54. La valeur de la première fréquence propre F1 du premier filtre 40 est calculée selon la formule de Thomson :

$$F1 = \frac{1}{2\pi\sqrt{L1 \cdot C1}}$$

avec L1 la valeur de l'inductance de la première bobine électromagnétique 50 et C1 la valeur de capacité du premier condensateur 54. Plus la valeur L1 de l'inductance et/ou la valeur C1 de capacité est grande, plus la fréquence propre F1 du premier filtre 40 est petite.

La valeur de la deuxième fréquence propre F2 du deuxième filtre 42 dépend, de manière similaire, des valeurs de l'inductance de la deuxième bobine électromagnétique 52 et de la capacité du deuxième condensateur 56 selon la formule de Thomson :

$$F2 = \frac{1}{2\pi\sqrt{L2 \cdot C2}}$$

avec L2 la valeur de l'inductance de la deuxième bobine électromagnétique 52 et C2 la valeur de capacité du deuxième condensateur 56.

La première fréquence propre F1 du premier filtre 40 est distincte de la deuxième fréquence propre F2 du deuxième filtre 42. La fréquence de filtrage F0 du filtre ainsi constitué est comprise entre les première et deuxième fréquences propres F1, F2 des premier et deuxième filtres 40, 42.

La fréquence de filtrage F0 est par exemple comprise entre 1 MHz et 10 MHz, par exemple sensiblement égale à 5 MHz. La première fréquence propre F1 du premier filtre 40 est inférieure à la fréquence de filtrage F0, par exemple comprise entre 1 MHz et 4,5 MHz, de préférence sensiblement égale à 4,5 MHz, et la deuxième fréquence propre F2 du deuxième filtre 42 est supérieure à la fréquence de filtrage F0, par exemple comprise entre 5,5 MHz et 10 MHz, de préférence sensiblement égale à 5,5 MHz.

En variante, la première fréquence propre F1 du premier filtre 40 est supérieure à la fréquence de filtrage F0, et la deuxième fréquence propre F2 du deuxième filtre 42 est alors inférieure à la fréquence de filtrage F0.

Le fonctionnement du système d'alimentation électrique 10, et en particulier du circuit électrique de filtrage 34, va être à présent décrit.

Lorsque le moteur 12 est alimenté à partir d'une tension d'alimentation fournie par la caténaire 16, un courant passe successivement par les premier et deuxième filtres 40, 42. Chaque filtre 40, 42 absorbe au moins partiellement le courant à la fréquence propre F1, F2 respective.

De préférence, les première et deuxième fréquences propres F1, F2 sont choisies dans une bande de fréquences correspondant à une bande de fréquences de réception d'une antenne, afin d'atténuer les perturbations de réception dues au courant d'alimentation et d'améliorer alors la compatibilité électromagnétique, également appelé EMC (de l'anglais *ElectroMagnetic Compatibility*), de l'antenne de réception. L'antenne est par exemple disposée sous un châssis du véhicule ferroviaire 1. Par exemple, les antennes dans le système européen de surveillance du trafic ferroviaire (ou ERTMS de l'anglais *European Rail Traffic Management System*) reçoivent dans une bande de fréquences autour de 4,2 MHz telle que la bande entre 3,9 MHz et 4,5 MHz. La première fréquence propre F1 est par exemple sensiblement égale à 4,1 MHz et la deuxième fréquence propre F2 est par exemple sensiblement égale à 5 MHz. Le circuit électrique de filtrage 34 atténue les perturbations d'au moins 20 dB dans la bande de 3,9 MHz à 4,5 MHz autour des première et deuxième fréquences propres F1, F2. Une réception correcte des signaux ERTMS est alors possible dans une bande de fréquences suffisamment large autour de la fréquence de filtrage F0 sensiblement égale à 4,2 MHz. La compatibilité électromagnétique avec l'antenne de réception est alors améliorée.

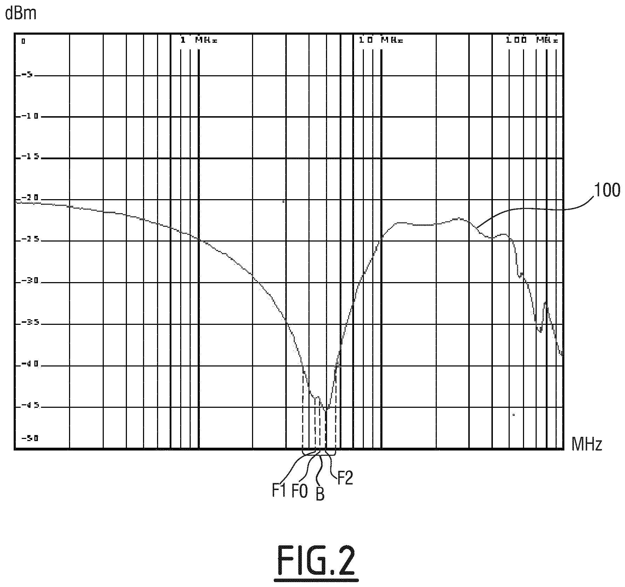

Sur la figure 2, un exemple de l'atténuation obtenue via le circuit électrique de filtrage 34 est représenté. La courbe 100 représente une courbe de réponse en fréquence du circuit de filtrage 34 selon l'invention, avec un niveau de signal exprimé en ordonnée et en dBm. L'abscisse désigne les fréquences correspondantes exprimées en MHz et en échelle logarithmique.

Dans l'exemple de la figure 2, la première fréquence propre F1 du premier filtre 40 est inférieure à la fréquence de filtrage F0. La fréquence propre F2 du deuxième filtre 42 est supérieure à la fréquence de filtrage F0. Les première et deuxième fréquences propres F1, F2 sont proches de la fréquence de filtrage F0. Par exemple, la première fréquence propre F1 est sensiblement égale à 4,1 MHz, la fréquence de filtrage F0 sensiblement égale à 4,2 MHz et la deuxième fréquence propre sensiblement égale à 5 MHz.

La perturbation est diminuée pour les première et deuxième fréquences propres F1, F2 et dans une bande de fréquences B autour des première et deuxième fréquences propres F1, F2. En somme, une atténuation de la perturbation électromagnétique est effectuée dans une bande plus large autour de la fréquence de filtrage F0. En particulier, la perturbation électromagnétique est diminuée dans la bande de fréquences B de 3,8 MHz à 4,8 MHz. L'atténuation de la perturbation est par exemple maximale à la deuxième fréquence propre F2. La perturbation électromagnétique est minimale dans la bande de fréquences B.

Dans l'exemple de la figure 2, la valeur minimale de l'atténuation obtenue via le circuit électrique de filtrage 34 est sensiblement égale à 20 dB entre 3,8 MHz et 4,8 MHz. La valeur maximale de l'atténuation est celle obtenue autour de la fréquence centrale de filtrage F0, et est alors sensiblement égale à 23 dB. La largeur de la bande de fréquences B est sensiblement égale à 1 MHz. Dans cette bande de fréquences B, l'atténuation obtenue via le circuit électrique de filtrage 34 est supérieure ou égale à 20 dB.

Le circuit électrique de filtrage 34 selon l'invention comprend alors deux filtres LC connectés en série et permet de filtrer des perturbations du courant d'alimentation du véhicule ferroviaire 1 dans une bande de fréquences suffisamment large pour permettre une bonne réception radioélectrique de signaux via des antennes de réception. Avec le système d'alimentation électrique 10 selon l'invention, les premier et deuxième filtres 40, 42 sont reliés en série pour atténuer une bande plus large de fréquences.

On conçoit ainsi que le circuit électrique de filtrage 34 offre un filtrage amélioré et permet notamment de filtrer une bande de fréquences du courant d'alimentation du véhicule ferroviaire 1, afin d'avoir une réception de signaux radioélectriques avec une moindre perturbation.

**Revendications**

1. Circuit électrique (34) de filtrage d'une alimentation électrique d'un véhicule ferroviaire (1), le véhicule étant alimenté via un pantographe (30) propre à être en contact électrique avec une caténaire (16), le circuit électrique de filtrage (34) comprenant un premier filtre (40), le premier filtre (40) comportant une première bobine électromagnétique (50) et un premier condensateur (54) connecté en parallèle de la première bobine électromagnétique (50), le premier filtre (40) ayant une première fréquence propre (F1), **caractérisé en ce que** le circuit électrique de filtrage (34) comprend en outre un deuxième filtre (42), le deuxième filtre (42) comportant une deuxième bobine électromagnétique (52) et un deuxième condensateur (56) connecté en parallèle de la deuxième bobine électromagnétique (52), le deuxième filtre (42) ayant une deuxième fréquence propre (F2) distincte de la première fréquence propre (F1), le premier filtre (40) et le deuxième filtre (42) étant connectés en série et étant configurés pour être disposés entre le pantographe (30) et un transformateur (36) relié électriquement à une roue (14) du véhicule ferroviaire (1), l'un des premier et deuxième filtres (40, 42) étant configuré pour être connecté directement au transformateur (36).

2. Circuit électrique de filtrage (34) selon la revendication 1, dans lequel le premier filtre (40) et le deuxième filtre (42) sont connectés entre eux par un point intermédiaire (60) et seule une extrémité (62) de l'un des premier et deuxième filtres (40, 42) est configurée pour être connectée au transformateur (36).

3. Circuit électrique de filtrage (34) selon la revendication 2, dans lequel le point intermédiaire (60) est configuré pour ne pas être directement connecté au transformateur (36).

4. Circuit électrique de filtrage (34) selon l'une quelconque des revendications précédentes, dans lequel le circuit électrique de filtrage (34) est configuré pour filtrer des fréquences autour d'une fréquence de filtrage (F0), la fréquence de filtrage (F0) étant comprise entre les première et deuxième fréquences propres (F1, F2).

5. Circuit électrique de filtrage (34) selon la revendication 4, dans lequel la valeur de la fréquence de filtrage (F0) est comprise entre 1 MHz et 10 MHz.

6. Système (10) d'alimentation d'un véhicule ferroviaire (1), le système d'alimentation (10) comprenant :

   - un pantographe (30),
   - un disjoncteur (32),
   - un circuit électrique de filtrage (34), et
   - un transformateur (36),

   le pantographe (30), le disjoncteur (32), le circuit électrique de filtrage (34) et le transformateur (36) étant connectés en série et étant configurés pour être connectés électriquement entre une caténaire (16) et une roue (14) du véhicule ferroviaire (1),

**caractérisé en ce que** le circuit électrique de filtrage (34) est selon l'une quelconque des revendications précédentes.

7. Système d'alimentation (10) selon la revendication 6, dans lequel le système d'alimentation (10) comprend en outre un convertisseur d'énergie électrique (38) configuré pour alimenter électriquement un moteur électrique (12), le convertisseur d'énergie électrique (38) étant connecté au transformateur (36).

8. Système d'alimentation (10) selon la revendication 6 ou 7, dans lequel le transformateur (36) comporte un enroulement primaire (39A) et un enroulement secondaire (39B), et le circuit électrique de filtrage (34) est connecté à l'enroulement primaire (39A).

9. Système d'alimentation (10) selon la revendication 7 ou 8, dans lequel le transformateur (36) comporte un enroulement primaire (39A) et un enroulement secondaire (39B), et le convertisseur d'énergie électrique (38) est connecté à l'enroulement secondaire (39B).

10. Véhicule ferroviaire (1) comprenant :

- un moteur électrique (12),
- un système (10) d'alimentation du moteur électrique (12),

**caractérisé en ce que** le système d'alimentation (10) est selon l'une quelconque des revendications 6 à 9.


**Patentansprüche**

1. Elektrischer Schaltkreis (34) zum Filtern einer elektrischen Versorgung eines Schienenfahrzeugs (1), wobei das Fahrzeug über einen Stromabnehmer (30) versorgt wird, der geeignet ist, in elektrischem Kontakt mit einer Oberleitung (16) zu sein, wobei der elektrische Filterschaltkreis (34) ein erstes Filter (40) umfasst, das eine erste elektromagnetische Spule (50) und einen ersten Kondensator (54), der parallel zur ersten elektromagnetischen Spule (50) geschaltet ist, aufweist, wobei das erste Filter (40) eine erste Eigenfrequenz (F1) hat,

**dadurch gekennzeichnet, dass** der elektrische Filterschaltkreis (34) außerdem ein zweites Filter (42) umfasst, das eine zweite elektromagnetische Spule (52) und einen zweiten Kondensator (56), der parallel zur zweiten elektromagnetischen Spule (52) geschaltet ist, aufweist, wobei das zweite Filter (42) eine zweite Eigenfrequenz (F2) unterschiedlich zu ersten Eigenfrequenz (F 1) aufweist,

wobei das erste Filter (40) und das zweite Filter (42) in Reihe geschaltet sind und ausgebildet sind, zwischen den Stromabnehmer (30) und einem Transformator (36), der elektrische mit einem Rad (14) des Schienenfahrzeugs (1) verbunden ist, angeordnet zu werden, wobei eines des ersten und zweiten Filters (40, 42) ausgebildet ist, direkt an den Transformator (36) angeschlossen zu werden.

2. Elektrischer Filterschaltkreis (34) nach Anspruch 1, bei dem das erste Filter (40) und das zweite Filter (42) untereinander über einen Zwischenpunkt (60) verbunden sind und nur ein Ende (62) eines des ersten und zweiten Filters (40, 42) ausgebildet ist, an den Transformator (36) angeschlossen zu werden.

3. Elektrischer Filterschaltkreis (34) nach Anspruch 2, bei dem der Zwischenpunkt (60) ausgebildet ist, nicht direkt an den Transformator (36) angeschlossen zu werden.

4. Elektrischer Filterschaltkreis (34) nach einem beliebigen der vorhergehenden Ansprüche, bei dem der elektrische Filterschaltkreis (34) ausgebildet ist, Frequenzen um eine Filterfrequenz (F0) herum zu filtern, wobei die Filterfrequenz (F0) zwischen der ersten und zweiten Eigenfrequenz (F1, F2) liegt.

5. Elektrischer Filterschaltkreis (34) nach Anspruch 4, bei dem der Wert der Filterfrequenz (F0) zwischen 1 MHz und 10 MHz liegt.

6. System (10) zur Versorgung eines Schienenfahrzeuges (1), wobei das Versorgungssystem (10) umfasst:

- einen Stromabnehmer (30),
- einen Trennschalter (32),
- einen elektrischen Filterschaltkreis (34) und
- einen Transformator (36),

wobei der Stromabnehmer (30), der Trennschalter (32), der elektrische Filterschaltkreis (34) und der Transformator (36) in Reihe geschaltet sind und ausgebildet sind, elektrisch zwischen einer Oberleitung (16) und einem Rad (14) des Schienenfahrzeugs (1) geschaltet zu werden, **dadurch gekennzeichnet, dass** der elektrische Filterschaltkreis (34) nach einem beliebigen der vorhergehenden Ansprüche ausgebildet ist.

7. Versorgungssystem (10) nach Anspruch 6, bei dem das Versorgungssystem (10) außerdem einen elektrischen Energiewandler (38) umfasst, der ausgebildet ist, elektrisch einen elektrischen Motor (12) zu versorgen, wobei der elektrische Energiewandler (38) mit dem Transformator (36) verbunden ist.

**8.** Versorgungssystem (10) nach Anspruch 6 oder 7, bei dem der Transformator (36) eine Primärwicklung (39A) und eine Sekundärwicklung (39B) aufweist, wobei der elektrische Filterschaltkreis (34) mit der Primärwicklung (39A) verbunden ist.

**9.** Versorgungssystem (10) nach Anspruch 7 oder 8, bei dem der Transformator (36) eine Primärwicklung (39A) und eine Sekundärwicklung (39B) aufweist und der elektrische Energiewandler (38) mit der Sekundärwicklung (39B) verbunden ist.

**10.** Schienenfahrzeug (1), umfassend:

- einen elektrischen Motoren (12),
- ein System (10) zur Versorgung des elektrischen Motors (12),

**dadurch gekennzeichnet, dass** das Versorgungssystem (10) nach einem beliebigen der Ansprüche 6 bis 9 ausgebildet ist.

**Claims**

**1.** Electrical circuit (34) for filtering an electrical supply of a railway vehicle (1), the vehicle being supplied via a pantograph (30) which is suitable for being in electrical contact with a catenary (16), the electrical filter circuit (34) comprising a first filter (40), the first filter (40) comprising a first electromagnetic coil (50) and a first capacitor (54) which is connected in parallel to the first electromagnetic coil (50), the first filter (40) having a suitable first frequency (F1), **characterised in that** the electrical filter circuit (34) comprises in addition a second filter (42), the second filter (42) comprising a second electromagnetic coil (52) and a second capacitor (56) which is connected in parallel to the second electromagnetic coil (52), the second filter (42) having a suitable second frequency (F2) which is different from the suitable first frequency (F1), the first filter (40) and the second filter (42) being connected in series and being configured to be disposed between the pantograph (30) and a transformer (36) which is connected electrically to a wheel (14) of the railway vehicle (1), one of the first and second filters (40, 42) being configured to be connected directly to the transformer (36).

**2.** Electrical filter circuit (34) according to claim 1, in which the first filter (40) and the second filter (42) are connected to each other by an intermediate point (60) and only one end (62) of one of the first and second filters (40, 42) is configured to be connected to the transformer (36).

**3.** Electrical filter circuit (34) according to claim 2, in which the intermediate point (60) is configured to not be directly connected to the transformer (36).

**4.** Electrical filter circuit (34) according to any of the preceding claims, in which the electrical filter circuit (34) is configured to filter frequencies about a filter frequency (F0), the filter frequency (F0) being between the first and second suitable frequencies (F1, F2).

**5.** Electrical filter circuit (34) according to claim 4, in which the value of the filter frequency (F0) is between 1 MHz and 10 MHz.

**6.** System (10) for supplying a railway vehicle (1), the supply system (10) comprising:

- a pantograph (30),
- a circuit breaker (32),
- an electrical filter circuit (34), and
- a transformer (36),

the pantograph (30), the circuit breaker (32), the electrical filter circuit (34) and the transformer (36) being connected in series and being configured to be connected electrically between a catenary (16) and a wheel (14) of the railway vehicle (1), **characterised in that** the electrical filter circuit (34) is according to any of the preceding claims.

**7.** Supply system (10) according to claim (6), in which the supply system (10) comprises in addition an electrical energy converter (38) which is configured to supply electrically an electric motor (12), the electrical power convertor (38) being connected to the transformer (36).

**8.** Supply system (10) according to claim 6 or 7, in which the transformer (36) comprises a primary winding (39A) and a secondary winding (39B), and the electrical filter circuit (34) is connected to the primary winding (39A).

**9.** Supply system (10) according to claim 7 or 8, in which the transformer (36) comprises a primary winding (39A) and a secondary winding (39B), and the electrical energy convertor (38) is connected to the secondary winding (39B).

**10.** Railway vehicle (1) comprising:

- an electric motor (12),
- a system (10) for supplying the electric motor (12),

**characterised in that** the supply system (10) is according to any of the claims 6 to 9.

FIG.1

**FIG.2**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2418570 A1